# EUROPÄISCHE PATENTSCHRIFT

(11) **EP 1 214 787 B1**
(45) Veröffentlichungstag und Bekanntmachung des Hinweises auf die Patenterteilung: **18.06.2003**
(21) Anmeldenummer: 00962516.1
(22) Anmeldetag: 21.09.2000
(51) Int. Cl.: H03K 17/955

(54) **VERFAHREN ZUR DETEKTION UND AUSWERTUNG KLEINER KAPAZITÄTSÄNDERUNGEN ZUR UMSETZUNG IN EIN SCHALTSIGNAL UND KAPAZITIVER SENSOR HIERZU**
METHOD FOR DETECTING AND EVALUATING SMALL CAPACITANCE VARIATIONS FOR CONVERTING INTO A SWITCHING SIGNAL AND A CORRESPONDING CAPACITIVE SENSOR
PROCEDE DE DETECTION ET D'EVALUATION DE PETITES VARIATIONS DE CAPACITE POUR CONVERSION EN UN SIGNAL DE COMMUTATION, ET CAPTEUR CAPACITIF CORRESPONDANT

(30) Priorität: 22.09.1999 DE 19945330
(43) Veröffentlichungstag der Anmeldung: 19.06.2002
(73) Patentinhaber: Sie Sensorik Industrie-Elektronik GmbH, 68519 Vierheim (DE)
(72) Erfinder: WINKENS, Frank, 67067 Ludwigshafen (DE)
(74) Vertreter: Mierswa, Klaus
(86) Internationale Anmeldenummer: EP0009258
(87) Internationale Veröffentlichungsnummer: WO01022586

(56) Entgegenhaltungen:
- DE-A- 19 836 054

## Beschreibung

### Technisches Gebiet:

Die Erfindung betrifft ein Verfahren zur elektrischen Detektion und Auswertung kleiner Kapazitätsänderungen zur Umsetzung in ein Schaltsignal, unter Verwendung eines elektrischen Verstärkers, dessen positiver oder negativer Versorgungsanschluss an eine positive oder negative Gleichspannungsversorgungsquelle und dessen anderer Versorgungsanschluss an ein Bezugspotential gelegt ist, wobei an den Eingang des Verstärkers eine einem zu detektierenden Objekt gegenüber relativ beweglich angeordnete Elektrode angeschlossen ist, gemäß dem Oberbegriff des Anspruchs 1.

### Stand der Technik:

Die Auswertung von kleinen bis sehr kleinen Kapazitätsänderungen ist eine immer wiederkehrende Aufgabe in der Sensortechnik. Insbesondere bei kapazitiven Näherungsschaltern müssen sehr kleine Kapazitätsänderungen, nämlich in einem Größenbereich < 10 fF, sicher ausgewertet werden, wobei hier vor allem der Störfestigkeit sowie der Temperaturstabilität der betreffenden Schaltung eine zentrale Bedeutung zukommt.

Es ist eine Reihe von auf kapazitiver oder induktiver Basis arbeitenden elektrischen Sensoren bekannt, die gewöhnlich einen kontakt- und berührungslos arbeitenden Initiator enthalten, der einen Hf-Oszillator in einer Sperrschwingerschaltung mit einem aktiven LC- oder RC-Schwingkreis aufweist. Handelt es sich um einen LC-Initiator, so ist die Induktivität des LC-Schwingkreises als Spule mit gerichtetem Hf-Feld ausgebildet. Wird in das Feld ein elektrisch leitendes Medium gebracht, tritt eine Dämpfung im Schwingkreis auf. Bei genügend großer Dämpfung gemäß dem Abstand des Mediums von der Spule des LC-Schwingkreises reißt die Schwingung des Oszillators ab, wobei diese Zustandsänderung innerhalb eines Auswerters in einen Schaltbefehl umgesetzt wird. Handelt es sich um einen RC-Initiator, so ist die Sensorelektrode Teil des Kondensators des RC-Schwingkreises, dessen Kapazität sich bei der Annäherung eines Objektes mit hinreichend großer Dielektrizitätszahl an die Sensorelektrode zu ändern imstande ist, wodurch der RC-Schwingkreis zu Schwingungen angeregt wird oder die Schwingungen abreißen und die Änderung der Schwingungsamplitude in einem nachgeschalteten Hüllkurvendemodulator ausgewertet werden können. Schalter mit derartigen Sensoren besitzen die Eigenschaft, daß der Schaltabstand von den Materialeigenschaften und der Beschaffenheit des zu detektierenden Körpers abhängt.

Somit bewirkt die Veränderung der Kapazität einer aktiven Fläche eine Veränderung der Frequenz, die ausgewertet werden kann.

Durch die DE 34 08 261 A1 ist ein Annäherungsschalter sowie eine Schaltungsanordnung hierfür bekanntgeworden, bei der eine Langzeit-Mittelwertbildung des Empfängersignals stattfindet. Der Annäherungsschalter besitzt einen Sender und einen Empfänger zum Empfang der vom Sender ausgesandten und von einem Objekt reflektierten Strahlung. Ein Langzeit-Mittelwertbildner bildet einen Langzeit-Mittelwert des Empfangssignals, welches mit einem Komparatorsignal verglichen wird. Das Komparatorsignal ist ein Kurzzeitsignal, welches den momentanen Wert des Empfangssignals repräsentiert, mit dem Langzeit-Signal vergleicht, wobei dann ein Komparatorsignal abgegeben wird, wenn die Abweichung des Kurzzeit-Signals vom Langzeit-Signal einen bestimmten Betrag überschreitet. Innerhalb eines Sperrkreises wird die Neubildung eines Langzeit-Mittelwertes durch den Langzeit-Mittelwertbildner während derjenigen Zeit unterbunden, in der ein Ausgangssignal des Komparators vorliegt, welches zur Bildung des Ausgangssignals der Schaltanordnung verwendet wird.

Durch die DE 42 10 848 A1 ist eine Sicherheitseinrichtung mit Auswerteeinrichtung bekanntgeworden, der eine Meßstelle sowie ein Abschlußwiderstand elektrisch zugeordnet ist und eine der Auswerteeinrichtung zugeordnete Anzeigeeinrichtung in Abhängigkeit eines von der Meßstelle abgegebenen Signals betätigen kann. Zwischen der Meßstelle und der Anzeigeeinrichtung ist eine ein Vergleichssignal liefernde Vergleichseinrichtung vorgesehen, die die Anzeigeeinrichtung derart ansteuert, daß zumindest zwei Zustände des Vergleichssignals aktiv signalisiert werden.

Derartige Sensoren weisen generell den Nachteil auf, daß aufgrund der Temperaturabhängigkeit des Sensors keine gleichbleibende Empfindlichkeit gewährleistet ist. Dadurch kann bei einer einmal durchgeführten Justage des Sensors ein Verlassen des Schaltabstandes erfolgen oder es kann ein Anschwingen des Oszillators erfolgen, noch ehe ein Objekt oder Medium sich im Ansprechbereich befindet; dadurch ist der Schaltabstand über dem Temperaturbereich nicht konstant. Ebenso kann eine applikationsspezifische Justage des Sensors außerhalb der Spezifikationen des Sensors erforderlich sein, was äußerst schwierig zu bewerkstelligen sein kann. Des Weiteren zeigen derartige Sensoren eine große Richtungsabhängigkeit, was häufig nachteilig ist.

Ebenso besitzen derartige Sensoren den Nachteil, dass die Kapazität der aktiven Fläche stark von der Umgebung und deren Veränderungen abhängt.

Ein weiterer Nachteil liegt darin begründet, dass derartige RC-Oszillatoren eine große und breitbandige Störempfindlichkeit schon für kleinste elektrische Wechselfelder im Bereich der Arbeitsfrequenz aufweisen, die nur durch einen hohen Schaltungsaufwand zu beseitigen ist. Des Weiteren müssen derartige Sensoren oder Näherungsschalter die Vorgaben der Norm EN 61000-4-3 betreffend die Prüf- und Messverfahren der elektromagnetischen Verträglichkeit einhalten. Herkömmliche kapazitive Sensoren können gewisse EMV-Prüfungen, welche die Maschinenrichtlinie fordert, insbesondere leitungsgeführte Einströmungen durch Oberflächenwellen, in der Regel nicht bestehen.

Weitere bekannte Lösungen sind zum Beispiel in den DE-C2-31 43 114, DE-A1-39 11 009, DE-A1-195 36 198, DE-A1-197 01 899, CH-558 534, der EP-A1-0 723 166 sowie der DE 38 32 562 A1 enthalten.

### Technische Aufgabe:

Der Erfindung liegt die Aufgabe zugrunde, ein Verfahren sowie einen kapazitiven Sensor zur Durchführung dieses Verfahrens zu schaffen, welches bei sicherer Auswertung sehr kleiner Kapazitätsänderungen eine hohe Resistenz gegen elektrische Wechselfelder sowie eine hohe Störfestigkeit und eine hohe Temperaturstabilität aufweisen soll. Des Weiteren soll der Sensor mit vergleichsweise geringem Aufwand und somit preiswert realisierbar sein.

### Offenbarung der Erfindung und deren Vorteile:

Das erfindungsgemäße Verfahren besteht darin, dass an die Versorgungsanschlüsse (Plus+, Minus-) des Verstärkers ein Wechselspannungssignal aus positiven und negativen Halbwellen, wie Gleichtaktsignal oder Rechtecksignal, angelegt wird, so dass die Versorgungsspannung des Verstärkers konstant bleibt, jedoch Verstärker und Elektrode einen Spannungshub im Gleichtakt der positiven und negativen Halbwellen des Wechselspannungssignals durchlaufen, und bei Detektion eines Objektes ein von der Elektrode herrührendes Signal (Elektrodensignal) im Verstärker verstärkt und dieses am Ausgang des Verstärkers erscheinende verstärkte Wechselspannungssignal anschließend in einer Gleichrichterschaltung gleichgerichtet und gegen Erdpotential von der Wechselspannung entkoppelt, als Gleichspannung bzw. -strom zur Auswertung verwendet wird, wobei das gleichgerichtete verstärkte Wechselspannungssignal zum Erdpotential von der Größe des Blindwiderstandes zwischen Elektrode und Objekt direkt abhängig ist.

In einer vorteilhaften weiteren Ausgestaltung des Verfahrens pendelt der Verstärker zwischen einem minimalen und einem maximalen Spannungswert der Versorgungsspannung UB in Abhängigkeit von den positiven und negativen Halbwellen des Wechselspannungssignals gegenüber dem Erdpotential hin- und her. Der minimale Spannungswert der Versorgungsspannung UB beträgt dabei 0 Volt, bezogen auf Erdpotential, und der maximale Spannungswert 2UB. Das Wechselspannungssignal des Verstärkers kann eine Rechteckform besitzen, deren Arbeitsfrequenz zirka 20 kHz ± 5 kHz beträgt.

In einer weiteren Ausgestaltung des Verfahrens wie auch des Sensors besitzt der Verstärker in Bezug auf hohe Störfestigkeit einen kleinen Spannungsverstärkungsfaktor, vorzugsweise von 1:0,5 bis 1:100, insbesondere 1:1.

Bei einem kapazitiven Sensor gemäß dem Oberbegriff des Anspruchs 5 ist erfindungsgemäß an die Versorgungsanschlüsse (Plus+, Minus-) des Verstärkers ein Wechselspannungssignal aus positiven und negativen Halbwellen, wie Gleichtaktsignal oder Rechtecksignal, angelegt, so dass die Versorgungsspannung des Verstärkers konstant bleibt, jedoch Ver-stärker und Elektrode einen Spannungshub im Gleichtakt der positiven und negativen Halbwellen des Wechselspannungssignals durchlaufen, und bei Detektion eines Objektes ein von der Elektrode herrührendes Signal (Elektrodensignal) im Verstärker verstärkt und dieses am Ausgang des Verstärkers erscheinende verstärkte Wechselspannungssignal anschliessend in einer Gleichrichterschaltung gleichgerichtet und gegen Erdpotential von der Wechselspannung entkoppelt, als Gleichspannung bzw. -strom zur Auswertung verwendet wird, wobei das gleichgerichtete, verstärkte Wechselspannungssignal zum Erdpotential von der Größe des Blindwiderstandes zwischen Elektrode und Objekt direkt abhängig ist.

Das Verfahren und der kapazitive Sensor weisen den Vorteil auf, dass es eine hohe Resistenz gegen elektrische Wechselfelder aufweist, was auf der Tatsache beruht, dass der Verstärker selbst relativ unempfindlich ist, weil er einen kleinen Verstärkungsfaktor aufweist. Andererseits aber kann er durch die Beaufschlagung mit einem hohen Steuersignal ein ausreichendes Nutzsignal liefern. Durch einen hohen Steuerpegel und einer Rechteckkurvenform der Steuerspannung, was einen höheren Effektivwert ergibt, ergibt sich ein guter Störabstand zwischen Nutzsignal und einem Störfeld. Die Eigenemission ist durch die Verwendung einer niedrigen Arbeitsfrequenz, zum Beispiel 20 kHz, gering. Des Weiteren besitzt die Schaltung eine hohe Störfestigkeit und Temperaturstabilität und ist gegenüber eingekoppelten Störungen weitgehend unempfindlich. Ebenso ist der Sensor mit vergleichsweise geringem Aufwand realisierbar.

In einer weiteren Ausgestaltung des Sensors hängt der Spannungshub von der Differenz der Höhe der Gleichspannungsversorgung sowie der Amplitude des Wechselspannungssignals ab. In einer weiteren bevorzugten Ausgestaltung des Sensors ist die Amplitude des Wechselspannungssignals in der positiven Halbwelle gleich der Höhe der Gleichspannungsversorgung UB und weist in der negativen Halbwelle Massepotential bzw. Null Volt auf, so dass der resultierende Spannungshub aus den Spannungshüben an den Versorgungsanschlüssen (Plus+, Minus-) die Höhe der Gleichspannungsversorgung UB aufweist und konstant bleibt.

In einer weiteren Ausgestaltung des Sensors ist an den Verstärker ein Steuergenerator angeschlossen, welcher das Wechselspannungssignal aus positiven und negativen Halbwellen, wie Gleichtaktsignal oder Rechtecksignal, erzeugt, wobei der Steuergenerator einerseits direkt an den negativen Versorgungsanschluss (Minus-) des Verstärkers, der Minus- oder Masseeingang, und andererseits über einen Haltekondensator Ch an den positiven Versorgungsanschluss Plus+ des Verstärkers, der Plus-Eingang, gelegt ist, an den über eine Diode D die Gleichspannungsversorgungsquelle UB angeschlossen ist. Oder der Steuergenerator ist einerseits direkt an den positiven Versorgungsanschluss + des Verstärkers, Pluseingang +, und andererseits über einen Haltekondensator Ch an den negativen Versorgungsanschluss - des Verstärkers, Minus- oder Masseeingang -, gelegt, wobei die Diode umgekehrt gepolt zwischen dem Minusanschluss - des Verstärkers und der Masse eingefügt ist, so dass der Verstärker an seinem positiven bzw. negativen Versorgungsanschluss, Plus+, Minus-, von der negativen bis zur positiven, oder umgekehrt, Halbwelle einen Spannungshub von der einfachen bis zur doppelten Höhe der Gleichspannungsversorgung UB und an seinem negativen bzw. positiven, oder umgekehrt, Versorgungsanschluss, Plus+, Minus-, einen Spannungshub vom Bezugspotential, vorzugsweise Erdpotential, bis zur Höhe der Gleichspannungsversorgung UB durchläuft und die Differenz der Spannungshübe konstant bleibt, nämlich in Höhe der Gleichspannungsversorgung UB.

Das Ausgangssignal des Steuergenerators ist bei einer vorteilhaften weitere Ausgestaltung gleichzeitig auf zwei symmetrisch aufgebaute Emitterfolger in NPN- und PNP-Technik aufgegeben, wobei die Ausgänge der Emitterfolger jeweils an den positiven und den negativen Versorgungsanschluss, Plus+, Minus-, des Verstärkers gelegt sind.

Ebenso ist der Steuergenerator bei einer vorteilhaften weiteren Ausgestaltung des Sensors über ein RC-Glied an den gemeinsamen Gabelpunkt der Emitterfolger gelegt, wobei der Widerstand des RC-Gliedes die Amplitude des Verstärkers im Verhältnis zum Gesamtwiderstand bestimmt.

Der Verstärker des Sensors besitzt einen konstanten Amplitudengang innerhalb einer vorgegebenen Bandbreite, die vorzugsweise größer als 50Hz ist und bis zu 150 kHz beträgt, so dass niederfrequente Störfelder, wie Brummfelder oder Frequenzen im 50Hz-Bereich, oder hohe Frequenzen, vorzugsweise oberhalb von 150 kHz, beschnitten werden und sich die Arbeitsfrequenz des Steuergenerators innerhalb dieser vorgegebenen Bandbreite ohne Einfluss auf den Schaltabstand bewegt. Damit hat die Steuergeneratorfrequenz in Grenzen keinen Einfluß auf den Schaltabstand.

In einer weiteren Ausgestaltung weist der Verstärker ein Bandpaßfilter auf mit maximaler Verstärkung für eine vorgegebene Frequenz, wobei die Arbeitsfrequenz des Steuergenerators einstellbar und veränderbar ist, so dass auf diese Weise die Empfindlichkeitseinstellung des Sensors erfolgt. In dieser Konstellation kann über die Arbeitsfrequenzeinstellung am Steuergenerator die Empfindlichkeitseinstellung, nämlich der Schaltabstand, erfolgen. Je näher die Arbeitsfrequenz des Generators am Bandpaßmaximum liegt, desto empfindlicher wird der Sensor.

Nach dem Gleichrichter kann ein Komparator geschaltet sein, der zur Einstellung des Schaltabstandes eine vorgebbare, konstante Komparatorschwelle aufweist. Der Schaltabstand des Sensors ist vorzugsweise bei konstanter Komparatorschwelle entweder über die vorgebbare Höhe der Gleichspannungsversorgung UB oder über die Höhe der Ausgangsspannung des Steuergenerators einstellbar.

### Kurzbeschreibung der Zeichnung, in der zeigen:

- Figur 1: ein Prinzipschaltbild eines kapazitiven Sensors mit gleichtaktiger Ansteuerung eines Verstärkers unter Verwendung eines Generators, einer Diode, einem Haltekondensator sowie einer nachgeschalteten Auswertung,
- Figur 2: ein Prinzipschaltbild eines in einem kapazitiven Sensor verwendeten weiteren Verstärkers mit der Ansteuerung durch zwei Transistoren
- Figur 3: ein Prinzipschaltbild der Auswerteschaltung des Sensors, wobei der im Sensor verwendete Verstärker innerhalb einer gewissen Bandbreite mit konstantem Amplitudengang als Breitband-Verstärker arbeitet
- Figur 4: die Darstellung der Abhängigkeit des Verstärkungsfaktors der Schaltung der Figur 3 von der Frequenz
- Figur 5: ein Prinzipschaltbild eines in einem Sensor verwendeten weiteren Verstärkers mit schmalbandiger Bandpasscharakteristik bei variablem Steuergenerator und
- Figur 6: die Darstellung der Abhängigkeit des Verstärkungsfaktors der Schaltung der Figur 5 von der Frequenz.

In den Figuren sind gleiche Elemente mit gleichen Bezugszeichen versehen.

### Wege zur Ausführung der Erfindung:

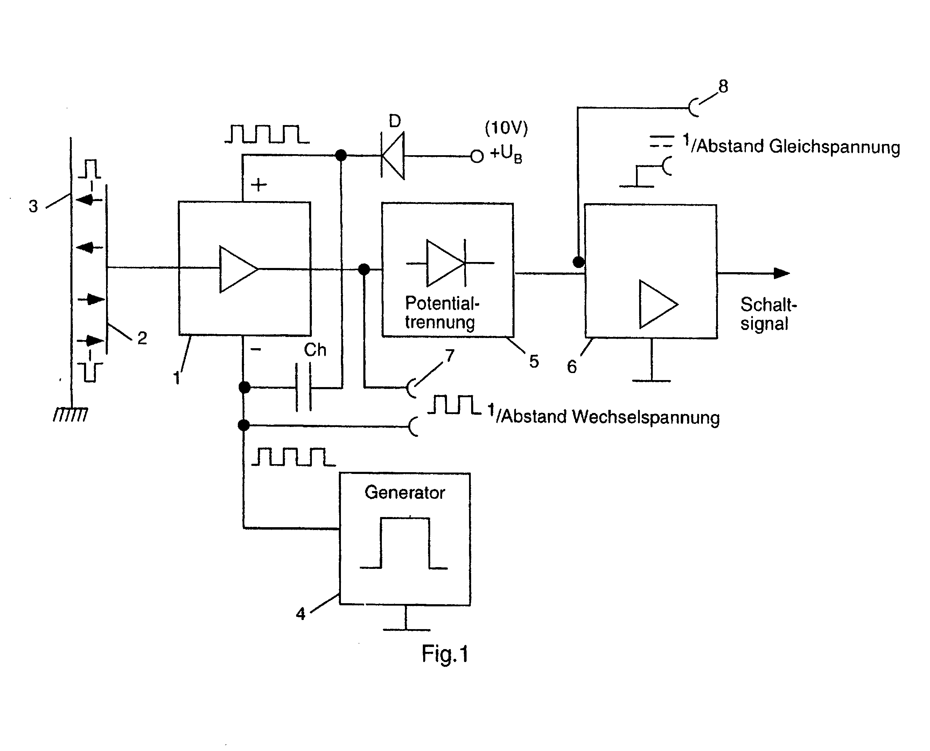

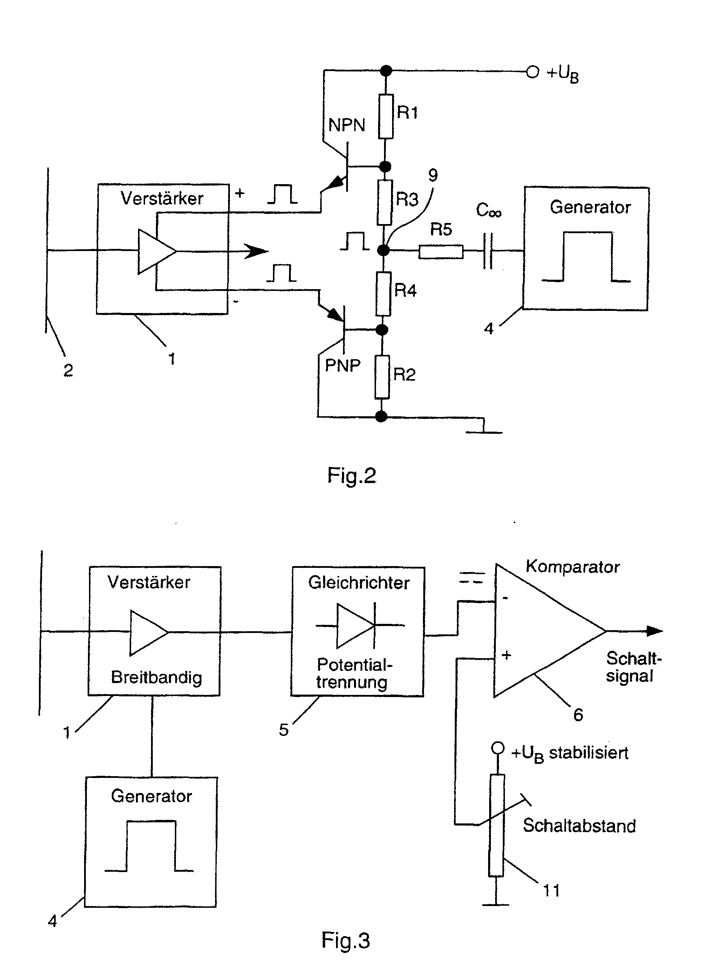

In der schaltungstechnischen Realisierung des erfindungsgemäßen Verfahrens gemäß den Figuren 1 oder 2 ergeben sich grundsätzlich mehrere unterschiedliche Ausgestaltungen, wobei Figur 1 eine Grundkonstellation darstellt. Ein Verstärker 1 mit relativ hochohmigen Eingang wird mit seinen Versorgungsanschlüssen Plus und Minus gegenüber einem vorgegebenen Potential, das vorzugsweise das Erdpotential ist, in einem vorgegebenen Gleichtakt durch einen Steuergenerator 4 bewegt, in dem ein Spannungshub an den Versorgungsanschlüssen erzeugt wird. Am Eingang des Verstärkers 1 ist eine Elektrode 2, zum Beispiel in Form einer Elektrodenplatte, angeschlossen, die einem zu detektierenden Objekt 3 gegenüber relativ beweglich ist; die Elektrode ist über die Eingangsimpedanz des Verstärkers an diesen angebunden. Bei Abwesenheit oder Unbewegtheit eines zu detektierenden Objektes läuft somit die Elektrode 2 entsprechend dem Gleichtaktsignal des Steuergenerators 4 gegenüber dem Bezugspotential, Erdpotential, mit.

Dadurch fließt prinzipiell in der positiven Halbwelle des Wechselspannungssignals des Steuergenerators 4 ein geringer Strom durch die Eingangsimpedanz des Verstärkers 1 zwischen Elektrode 2 und Objekt 3 bzw. zwischen Elektrode 2 und Erde infolge der Kapazität zum Erdpotential und in der negativen Halbwelle in umgekehrter Richtung. Bewegt sich nun ein zu detektierendes Objekt in den Schaltabstand hinein oder aus diesem hinaus, so verändert sich das in Ruhe der Elektrode 2 vorhandene Dielektrikum und dessen Dielektrizitätszahl εᵣ, so dass die Elektrode 2 vom Objekt 3 quasi festgehalten wird, es fließt ein sich ändernder Strom in den Eingang des Verstärkers 1. Dieser Wechselstrom wird durch den Verstärker 1 verstärkt, in eine Wechselspannung umgesetzt, gleichgerichtet und gegen Erdpotential bzw. Masse wieder als Gleichspannung zur Auswertung wieder zur Verfügung gestellt. Der Strom zum Bezugspotential bzw. Erdpotential ist direkt abhängig von der Größe des Blindwiderstandes bzw. der Kapazität zwischen der Elektrode 2 und dem Objekt 3. Die daraus abgeleitete Gleichspannung ist in Folge dessen ein direktes Maß für die Bedämpfung des Sensors bzw. für den Abstand d der Elektrode 2 zum Objekt 3 nach der Beziehung 1/d.

Die Figur 1 zeigt ein Prinzipschaltbild eines erfindungsgemäßen kapazitiven elektrischen Sensors, wie er zum Aufbau eines kapazitiven Näherungsschalters verwendet werden kann. An den Eingang des Verstärkers 1 ist die vorbeschriebene Elektrode 2 angeschlossen. An den positiven Versorgungsanschluss + des Verstärkers 1 ist über eine Diode D in Flußrichtung eine positive Gleichspannungsversorgungsquelle mit der Spannung U_{B} angeschlossen. An den negativen oder Masse Versorgungsanschluss des Verstärkers 1 ist ein Steuergenerator 4 angeschlossen, der ein Wechselspannungssignal aus positiven und negativen Halbwellen, wie Gleichtaktsignal oder Rechtecksignal, erzeugt. Gleichzeitig ist das Wechselspannungssignal über einen Haltekondensator Cₕ an die Versorgungsspannung U_{B} nach der Diode D gelegt.

Gemäß Figur 1 ist der negative Versorgungsanschluss oder Masseanschluß des Verstärkers direkt mit dem Ausgang des Steuergenerators 4 verbunden, seine Ausgangsspannung beträgt in der negativen Halbwelle Null Volt bzw. Massepotential, in der positiven Halbwelle hingegen das Potential in der Höhe der Versorgungsspannung U_{B}.

In der negativen Halbwelle des Wechselspannungssignals liegt der negative Versorgungsanschluss oder Masseanschluß des Verstärkers auf Null Volt oder Masse. Die Diode D ist leitend und der Verstärker 1 wird über die Diode D mit Versorgungsspannung U_{B} versorgt, der Haltekondensator Cₕ wird auf ein Potential der Höhe von U_{B} aufgeladen.

Somit liegen am negativen Versorgungsanschluss, Minus, des Verstärkers 1 in der negativen Halbwelle des Wechselspannungssignals Null Volt und in der positiven Halbwelle eine Spannung der Höhe U_{B} an; am positiven Versorgungsanschluss Plus des Verstärkers 1 liegen in der negativen Halbwelle des Wechselspannungssignals die Spannung U_{B} und in der positiven Halbwelle die Spannung 2·U_{B} an, bedingt durch die Verdopplung der Spannung U_{B} durch den Haltekondensator Cₕ. Der positive Versorgungsanschluss des Verstärkers 1 durchläuft somit einen Spannungshub von U_{B} bis 2·U_{B}, der negative Versorgungsanschluss durchläuft einen Spannungshub von Null Volt bis U_{B}. Daraus resultiert ein Spannungshub des Verstärkers von gleichbleibend der Höhe U_{B} im Gleichtakt der positiven und negativen Halbwellen des Wechselspannungssignals.

In der positiven Halbwelle des Wechselspannungssignals liegt der negative Versorgungsanschluss oder Masseanschluß des Verstärkers auf einem Potential der Versorgungsspannung U_{B}. Die Versorgungsspannung U_{B} wird über den Haltekondensator Cₕ gehalten. Die Diode D ist gesperrt, der positive Versorgungsanschluss des Verstärkers 1 liegt auf einem Potential von 2·U_{B}.

Bei Detektion eines Objektes 3 wird das von der Elektrode 2 herrührende Signal, Elektrodensignal, im Verstärker 1 dem Wechselspannungssignal überlagert und in eine Wechselspannung umgesetzt. Das am Ausgang des Verstärkers 1 erscheinende Wechselspannungssignal wird einer speziellen Gleichrichterschaltung bzw. einem Gleichrichter 5 aufgegeben und gleichgerichtet und gegen Erdpotential von der Wechselspannung entkoppelt und nun als Gleichspannung bzw. -strom zur Auswertung einem Komparator 6 aufgegeben, der daraus ein Schaltsignal ableitet. Das Wechselspannungssignal bzw. Überlagerungssignal am Ausgang des Verstärkers 1 am Abgriff 7 wie das gleichgerichtete, verstärkte Wechselspannungssignal nach dem Gleichrichter 5 am Abgriff 8 sind zum Erdpotential von der Größe des Blindwiderstandes zwischen Elektrode 2 und Objekt 3 direkt abhängig und gehorchen der Beziehung 1/d. Der Schaltabstand ist immer abhängig von der Komparatorschwelle, der Höhe der Steuerspannung aus dem Generator, der Eingangsimpedanz und dem Verstärkungsfaktor des Verstärkers für die jeweilige Steuerfrequenz aus dem Generator.

Zur Einstellung des Schaltabstandes kann der Komparator 6 eine vorgebbare, konstante oder auch veränderbare Komparatorschwelle aufweisen, die zum Beispiel mittels einer einstellbaren Sollgleichspannungseinrichtung, beispielsweise Sollgleichspannungseinrichtung 11 in Figur 3, vorgegeben werden kann.

Die Verhältnisse zwischen den Versorgungsanschlüssen des Verstärkers lassen sich natürlich auch elektrisch umkehren, so dass der Steuergenerator einerseits direkt an den positiven Versorgungsanschluss des Verstärkers, Plus-Eingang, und andererseits über einen Haltekondensator Ch an den negativen Versorgungsanschluss des Verstärkers, Minus- oder Masseeingang, gelegt ist, wobei die Diode D umgekehrt gepolt zwischen dem Minusanschluss des Verstärkers und der Masse eingefügt ist, so dass der Verstärker an seinem positiven bzw. negativen Versorgungsanschluss von der negativen bis zur positiven - oder umgekehrt - Halbwelle einen Spannungshub von der einfachen bis zur doppelten Höhe der Gleichspannungsversorgung U_{B} und an seinem negativen bzw. positiven, oder umgekehrt, Versorgungsanschluss einen Spannungshub vom Bezugspotential, vorzugsweise Erdpotential, bis zur Höhe der Gleichspannungsversorgung U_{B} durchläuft und die Differenz der Spannungshübe konstant bleibt, nämlich in Höhe der Gleichspannungsversorgung U_{B}.

Figur 2 zeigt ein Prinzipschaltbild eines in einem kapazitiven Sensor verwendeten Verstärkers mit der Ansteuerung des Steuergenerators 4 durch zwei Transistoren NPN und PNP. Das Ausgangssignal des Steuergenerators 4 wird gleichzeitig auf zwei symmetrisch aufgebaute Emitterfolger in NPN- und PNP-Technik aufgegeben, wobei die Ausgänge der Emitterfolger jeweils an den positiven und den negativen Versorgungsanschluss des Verstärkers 1 gelegt sind. Der Steuergenerator 4 ist über ein Reihen-RC-Glied R5 und C_{∞} an den gemeinsamen Gabelpunkt 9 der Emitterfolger gelegt. Der Widerstand R5 des RC-Gliedes bestimmt hauptsächlich die Amplitude der Steuerspannung im Verhältnis zum Gesamtwiderstand.

Zwischen der Versorgungsspannung einerseits U_{B} und andererseits Erd- oder Nullpotential der Transistoren NPN und PNP und dem gemeinsamen Gabelpunkt 9 der Emitterfolger sind je ein Spannungsteiler R1-R3 und R4-R2 gelegt, wobei zwischen den Widerständen R1 und R3 sowie R4 und R2 jeweils die Ansteuerleitung für die Basis der Transistoren NPN und PNP angeschlossen ist. Der Widerstand R5 des RC-Gliedes bestimmt hauptsächlich die Amplitude des Verstärkers 1 im Verhältnis zum Gesamtwiderstand.

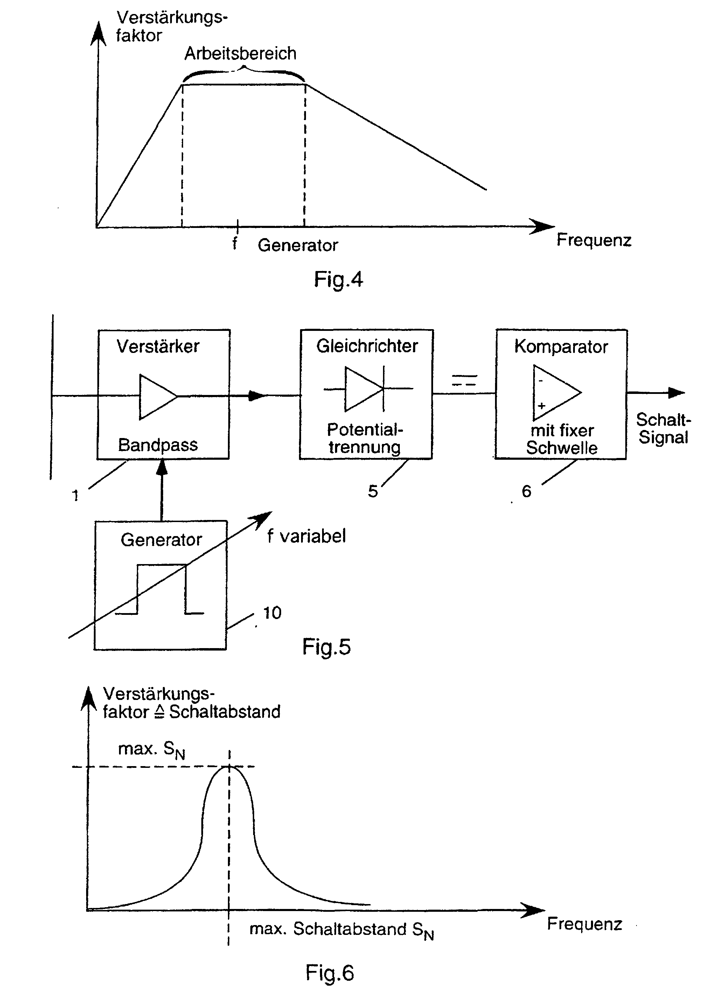

In Figur 3 ist ein Prinzipschaltbild der Auswerteschaltung des Sensors gezeigt, wobei der verwendete Verstärker 1 innerhalb einer gewissen Bandbreite, vorzugsweise größer als 50 Hz und kleiner als 150 kHz, mit einem konstanten Amplitudengang als Breitband-Verstärker arbeitet. Der Verstärker 1 mit breitbandigem Frequenzgang besitzt einen konstanten Amplitudengang innerhalb einer vorgegebenen Bandbreite (Figur 4), so dass nur sehr niedrige Störfelder, wie Brummfelder oder Frequenzen im 50Hz-Bereich, oder sehr hohe Frequenzen beschnitten werden, wobei sich die Arbeitsfrequenz des Steuergenerators 4, die etwas schwanken kann, innerhalb dieser vorgegebenen Bandbreite bewegt. Zur Einstellung des Schaltabstandes wird dem Komparator 6 eine einstellbare Komparatorschwelle vorgegeben, die mittels der Sollgleichspannungseinrichtung 11 eingestellt wird. In diesem Beispiel hat die Steuerfrequenz des Generators 4 in gewissen Grenzen keinen Einfluß auf den Schaltabstand; dieser wird nur über die Komparatorschwelle mit der Sollgleichspannungseinrichtung 11 eingestellt. Figur 4 zeigt das dazugehörige Schaubild der Darstellung der Abhängigkeit des Verstärkungsfaktors der Schaltung in Figur 3 von der Steuerfrequenz.

Figur 5 zeigt ein Prinzipschaltbild eines in einem Sensor verwendeten weiteren Verstärkers 1 mit schmalbandiger Bandpaßcharakteristik bei variablem Steuergenerator 10. Der Verstärker 1 weist ein Bandpaßfilter mit maximaler Verstärkung für eine vorgegebene Frequenz auf, wobei die Arbeitsfrequenz des Steuergenerators 10 einstellbar und veränderbar ist. In der Figur 6 ist hierzu die Abhängigkeit des Verstärkungsfaktors und somit des Schaltabstandes der Schaltung der Figur 5 von der Frequenz des Steuergenerators 10 dargestellt. Schmalbandig bedeutet hier eine Bandbreite von 1% bis 20% der verwendeten Mittenfrequenz; zum Beispiel 10 kHz bei Mittenfrequenz bis 150 kHz oder 1MHz bei Mittenfrequenz bis maximal 10 MHz.

Der Schaltabstand des Sensors bei konstanter Komparatorschwelle ist entweder über die vorgebbare Höhe der Gleichspannungsversorgung U_{B} oder über die Höhe der Ausgangsspannung des Steuergenerators 4 in gewissen Grenzen einstellbar.

### Gewerbliche Anwendbarkeit:

Der Gegenstand der Erfindung ist insbesondere zur sicheren Auswertung sehr kleiner Kapazitätsänderungen geeignet. Die Nützlichkeit der Erfindung liegt darin, dass sie eine hohe Resistenz gegen elektrische Wechselfelder aufweist, was darauf beruht, dass der Verstärker selbst relativ unempfindlich ist, weil er einen kleinen Verstärkungsfaktor aufweist, andererseits aber er durch die Beaufschlagung mit einem hohen Steuersignal ein ausreichendes Nutzsignal liefern kann. Durch das erfindungsgemäße Verfahren können die Vorgaben der Norm EN 61000-4-3 betreffend die Prüf- und Messverfahren der elektromagnetischen Verträglichkeit wie die Vorschriften der Maschinenrichtlinie eingehalten werden.

## Patentansprüche

1. Verfahren zur elektrischen Detektion und Auswertung kleiner Kapazitätsänderungen zur Umsetzung in ein Schaltsignal, unter Verwendung eines elektrischen Verstärkers (1), dessen positiver oder negativer Versorgungsanschluss (Plus+, Minus-) an eine positive oder negative Gleichspannungsversorgungsquelle (UB) und dessen anderer Versorgungsanschluss (Plus+, Minus-) an ein Bezugspotential gelegt ist, wobei an den Eingang des Verstärkers eine einem zu detektierenden Objekt (3) gegenüber relativ beweglich angeordnete Elektrode (2) angeschlossen ist, **dadurch gekennzeichnet, dass** an die Versorgungsanschlüsse (Plus+, Minus-) des Verstärkers (1) ein Wechselspannungssignal aus positiven und negativen Halbwellen, wie Gleichtaktsignal oder Rechtecksignal, angelegt wird, so dass die Versorgungsspannung des Verstärkers konstant bleibt, jedoch Verstärker (1) und Elektrode (2) einen Spannungshub im Gleichtakt der positiven und negativen Halbwellen des Wechselspannungssignals durchlaufen, und bei Detektion eines Objektes (3) ein von der Elektrode (2) herrührendes Signal (Elektrodensignal) im Verstärker (1) verstärkt und dieses am Ausgang des Verstärkers (1) erscheinende verstärkte Wechselspannungssignal anschließend in einer Gleichrichterschaltung gleichgerichtet und gegen Erdpotential von der Wechselspannung entkoppelt, als Gleichspannung bzw. -strom zur Auswertung verwendet wird, wobei das gleichgerichtete verstärkte Wechselspannungssignal zum Erdpotential von der Größe des Blindwiderstandes zwischen Elektrode (2) und Objekt (3) direkt abhängig ist.

2. Verfahren nach Anspruch 1, **dadurch gekennzeichnet,**
**dass** der Verstärker zwischen einem minimalen und einem maximalen Spannungswert seiner Versorgungsspannung (UB) in Abhängigkeit von den positiven und negativen Halbwellen des Wechselspannungssignals gegenüber dem Erdpotential hin- und herpendelt.

3. Verfahren nach Anspruch 1, **dadurch gekennzeichnet,**
**dass** das Wechselspannungssignal des Verstärkers eine Rechteckform besitzt, deren Arbeitsfrequenz zirka 20 kHz ± 5 kHz beträgt.

4. Verfahren nach Anspruch 1 oder 2, **dadurch gekennzeichnet,**
**dass** der Verstärker in Bezug auf hohe Störfestigkeit einen kleinen Spannungsverstärkungsfaktor besitzt, vorzugsweise von 1:0,5 bis 1:100, insbesondere 1:1.

5. Kapazitiver Sensor zur elektrischen Detektion und Auswertung kleiner Kapazitätsänderungen zur Umsetzung in ein Schaltsignal, mit einem elektrischen Verstärker (1), dessen positiver oder negativer Versorgungsanschluss (Plus+, Minus-) an eine positive oder negative Gleichspannungsversorgungsquelle (UB) und dessen anderer Versorgungsanschluss (Plus+, Minus-) an ein Bezugspotential gelegt ist, wobei an den Eingang des Verstärkers (1) eine einem zu detektierenden Objekt (3) gegenüber relativ beweglich angeordnete Elektrode (2) angeschlossen ist,
**dadurch gekennzeichnet,**
**dass** an die Versorgungsanschlüsse (Plus+, Minus-) des Verstärkers (1) ein Wechselspannungssignal aus positiven und negativen Halbwellen, wie Gleichtaktsignal oder Rechtecksignal, angelegt ist, so dass die Versorgungsspannung des Verstärkers konstant bleibt, jedoch Verstärker (1) und Elektrode (2) einen Spannungshub im Gleichtakt der positiven und negativen Halbwellen des Wechselspannungssignals durchlaufen, und bei Detektion eines Objektes (3) ein von der Elektrode (2) herrührendes Signal (Elektrodensignal) im Verstärker (1) verstärkt und dieses am Ausgang des Verstärkers (1) erscheinende verstärkte Wechselspannungssignal anschließend in einer Gleichrichterschaltung gleichgerichtet und gegen Erdpotential von der Wechselspannung entkoppelt, als Gleichspannung bzw. -strom zur Auswertung verwendet wird, wobei das gleichgerichtete, verstärkte Wechselspannungssignal zum Erdpotential von der Größe des Blindwiderstandes zwischen Elektrode (2) und Objekt (3) direkt abhängig ist.

6. Sensor nach Anspruch 5, **dadurch gekennzeichnet,**
**dass** der Spannungshub von der Differenz der Höhe der Gleichspannungsversorgung sowie der Amplitude des Wechselspannungssignals abhängt.

7. Sensor nach Anspruch 5 oder 6, **dadurch gekennzeichnet,**
**dass** die Amplitude des Wechselspannungssignals in der positiven Halbwelle gleich der Höhe der Gleichspannungsversorgung UB ist und in der negativen Halbwelle Massepotential bzw. Null Volt aufweist, so dass der resultierende Spannungshub aus den Spannungshüben an den Versorgungsanschlüssen (Plus+, Minus-) die Höhe der Gleichspannungsversorgung UB aufweist und konstant bleibt.

8. Sensor nach Anspruch 7, **dadurch gekennzeichnet,**
**dass** an den Verstärker (1) ein Steuergenerator (4) angeschlossen ist, welcher das Wechselspannungssignal aus positiven und negativen Halbwellen, wie Gleichtaktsignal oder Rechtecksignal, erzeugt, wobei der Steuergenerator (4) einerseits direkt an den negativen Versorgungsanschluss (Minus-) des Verstärkers (1), der Minus- oder Masseeingang, und andererseits über einen Haltekondensator (Ch) an den positiven Versorgungsanschluss (Plus+) des Verstärkers (1), der Pluseingang gelegt ist, an den über eine Diode (D) die Gleichspannungsversorgungsquelle UB angeschlossen ist,
oder dass der Steuergenerator (4) einerseits direkt an den positiven Versorgungsanschluss (+) des Verstärkers (1), Pluseingang (+), und andererseits über einen Haltekondensator (Ch) an den negativen Versorgungsanschluss (-) des Verstärkers (1), Minus- oder Masseeingang (-), gelegt ist,
wobei die Diode umgekehrt gepolt zwischen dem Minusanschluss (-) des Verstärkers (1) und der Masse eingefügt ist,
so dass der Verstärker (1) an seinem positiven bzw. negativen Versorgungsanschluss (Plus+, Minus-) von der negativen bis zur positiven, oder umgekehrt, Halbwelle einen Spannungshub von der einfachen bis zur doppelten Höhe der Gleichspannungsversorgung (UB) und an seinem negativen bzw. positiven, oder umgekehrt, Versorgungsanschluss (Plus+, Minus-) einen Spannungshub vom Bezugspotential, vorzugsweise Erdpotential, bis zur Höhe der Gleichspannungsversorgung (UB) durchläuft und die Differenz der Spannungshübe konstant bleibt, nämlich in Höhe der Gleichspannungsversorgung (UB).

9. Sensor nach Anspruch 5 oder 6 oder 7, **dadurch gekennzeichnet,**
**dass** das Ausgangssignal des Steuergenerators (4) gleichzeitig auf zwei symmetrisch aufgebaute Emitterfolger in NPN- und PNP-Technik aufgegeben ist,
wobei die Ausgänge der Emitterfolger jeweils an den positiven und den negativen Versorgungsanschluss (Plus+, Minus-) des Verstärkers (1) gelegt sind.

10. Sensor nach Anspruch 9, **dadurch gekennzeichnet,**
**dass** der Steuergenerator (4) über ein RC-Glied (R5,C∞) an den gemeinsamen Gabelpunkt der Emitterfolger gelegt ist, wobei der Widerstand (R5) des RC-Gliedes die Amplitude des Verstärkers (1) im Verhältnis zum Gesamtwiderstand bestimmt.

11. Sensor nach Anspruch 5 oder 6 oder 7, **dadurch gekennzeichnet,**
**dass** der Verstärker (1) einen konstanten Amplitudengang innerhalb einer vorgegebenen Bandbreite besitzt, so dass niederfrequente Störfelder, wie Brummfelder oder Frequenzen im 50Hz-Bereich, oder hohe Frequenzen, vorzugsweise oberhalb von 150 kHz, beschnitten werden und sich die Arbeitsfrequenz des Steuergenerators (4) innerhalb dieser vorgegebenen Bandbreite ohne Einfluss auf den Schaltabstand bewegt.

12. Sensor nach Anspruch 5 oder 6 oder 7, **dadurch gekennzeichnet,**
**dass** der Verstärker ein Bandpaßfilter aufweist mit maximaler Verstärkung für eine vorgegebene Frequenz und die Arbeitsfrequenz des Steuergenerators (4) einstellbar und veränderbar ist, so dass auf diese Weise die Empfindlichkeitseinstellung des Sensors erfolgt.

13. Sensor nach einem der vorherigen Ansprüche 5 bis 12,
**dadurch gekennzeichnet, dass** nach dem Gleichrichter (5) eine Komparator (6) geschaltet ist, der zur Einstellung des Schaltabstandes eine vorgebbare, konstante Komparatorschwelle aufweist.

14. Sensor nach einem der vorherigen Ansprüche 5 bis 12,
**dadurch gekennzeichnet, dass** der Schaltabstand des Sensors bei konstanter Komparatorschwelle entweder über die vorgebbare Höhe der Gleichspannungsversorgung UB oder über die Höhe der Ausgangsspannung des Steuergenerators (4) einstellbar ist.

## Claims

1. A method to electrically detect and evaluate small capacitance changes for conversion into a switching signal, involving the use of an electric amplifier (1) whose positive or negative supply connection (plus+, minus-) is connected to a positive or negative direct voltage supply source (U_{B}) and whose other supply connection (plus+, minus-) is connected to a reference potential, whereby an electrode (2) that is arranged relatively movably with respect to an object (3) to be detected is connected to the input of the amplifier, **characterized in that**
an alternating voltage signal of positive and negative half waves, such as a common mode signal or square-wave signal, is applied to the supply connections (plus+, minus-) of the amplifier (1), so that the supply voltage of the amplifier remains constant, but the amplifier (1) and the electrode (2) pass through a voltage level difference in the common mode of the positive and negative half waves and, when an object (3) is detected, a signal (electrode signal) coming from the electrode (2) is amplified in the amplifier and this amplified alternating voltage signal, which appears at the output of the amplifier (1), is subsequently rectified in a rectifier circuit and, uncoupled from the alternating voltage against the ground potential, is used as the direct voltage or direct current for evaluation purposes, whereby the rectified amplified alternating voltage signal to the ground potential depends directly on the magnitude of the reactive resistance between the electrode (2) and the object (3).

2. The method according to Claim 1, **characterized in that**
the amplifier oscillates back and forth between a minimal and a maximal voltage value of its supply voltage (U_{B}) as a function of the positive and negative half waves of the alternating voltage signal with respect to the ground potential.

3. The method according to Claim 1, **characterized in that**
the alternating voltage signal of the amplifier has a square-wave shape whose working frequency is about 20 kHz ± 5 kHz.

4. The method according to Claim 1 or 2, **characterized in that**
the amplifier has a small voltage transmission coefficient with regard to high interference immunity, preferably from 1:0.5 to 1:100, especially 1:1.

5. A capacitive sensor for the electric detection and evaluation of small capacitance changes for conversion into a switching signal, with an electric amplifier (1) whose positive or negative supply connection (plus+, minus-) is connected to a positive or negative direct voltage supply source (U_{B}) and whose other supply connection (plus+, minus-) is connected to a reference potential, whereby an electrode (2) that is arranged relatively movably with respect to an object (3) to be detected is connected to the input of the amplifier (1), **characterized in that**
an alternating voltage signal of positive and negative half waves, such as a common mode signal or square-wave signal, is applied to the supply connections (plus+, minus-) of the amplifier (1), so that the supply voltage of the amplifier remains constant, but the amplifier (1) and the electrode (2) pass through a voltage level difference in the common mode of the positive and negative half waves and, when an object (3) is detected, a signal (electrode signal) coming from the electrode (2) is amplified in the amplifier (1) and this amplified alternating voltage signal, which appears at the output of the amplifier (1), is subsequently rectified in a rectifier circuit and, uncoupled from the alternating voltage against the ground potential, is used as the direct voltage or direct current for evaluation purposes, whereby the rectified amplified alternating voltage signal to the ground potential depends directly on the magnitude of the reactive resistance between the electrode (2) and the object (3).

6. The sensor according to Claim 5, **characterized in that**
the voltage level difference depends on the difference in the level of the direct voltage supply as well as on the amplitude of the alternating voltage signal.

7. The sensor according to Claim 5 or 6, **characterized in that**
the amplitude of the alternating voltage signal in the positive half wave is equal to the level of the direct voltage supply U_{B} and it has ground potential or zero volt in the negative half wave, so that the resulting voltage level difference from the voltage level differences at the supply connections (plus+, minus-) has the level of the direct voltage supply U_{B} and remains constant.

8. The sensor according to Claim 7, **characterized in that**
a control generator (4) is connected to the amplifier (1), and said control generator (4) generates the alternating voltage signal from positive and negative half waves, such as a common mode signal or square-wave signal, whereby, on the one hand, the control generator (4) is connected directly to the negative supply connection (minus-) of the amplifier (1), to the minus or ground input, and on the other hand, via a holding condenser (Ch), to the positive supply connection (plus+) of the amplifier (1), to the plus input, to which the direct voltage supply source U_{B} is connected via a diode D,
or **in that**, on the one hand, the control generator (4) is connected directly to the positive supply connection (+) of the amplifier (1), plus input (+), and on the other hand, via a holding condenser (Ch) to the negative supply connection (-) of the amplifier, minus or ground input (-), whereby the diode is inserted with reversed polarity between the minus connection (-) of the amplifier (1) and of the ground,
so that the amplifier (1), at its positive or negative supply connection (plus+, minus-) passes through a voltage level difference from the negative half wave to the positive half wave, or vice-versa, of one time to two times the level of the direct voltage supply (U_{B}), and passes through a voltage level difference at its negative or positive supply connection (plus+, minus-), or vice-versa, of the reference potential, preferably ground potential, to the level of the direct voltage supply (U_{B}), and the difference of the voltage level differences remains constant, namely, at the level of the direct voltage supply (U_{B}).

9. The sensor according to Claim 5 or 6 or 7, **characterized in that**
the output signal of the control generator (4) is applied to two symmetrically configured emitter followers in NPN and PNP technology, whereby the outputs of the emitter followers are each connected to the positive and to the negative supply connection (plus+, minus-) of the amplifier (1).

10. The sensor according to Claim 9, **characterized in that**
the control generator (4) is likewise connected via an RC element (R5, C∞) to the shared two-to-four-wire transition point of the emitter followers, whereby the resistor (R5) of the RC element determines the amplitude of the amplifier (1) in relation to the total resistance.

11. The sensor according to Claim 5 or 6 or 7, **characterized in that**
the amplifier (1) has a constant frequency response of amplitude within a prescribed bandwidth, so that low-frequency inference fields, such as hum fields or frequencies in the 50 Hz range, or high frequencies, preferably above 150 kHz, are clipped and the working frequency of the control generator (4) moves within this prescribed bandwidth without having an influence on the switching distance.

12. The sensor according to Claim 5 or 6 or 7, **characterized in that**
the amplifier has a bandpass filter with maximal amplification for a prescribed frequency, and the working frequency of the control generator (4) can be adjusted and modified so that, in this manner, the sensitivity setting of the sensor is established.

13. The sensor according to one of the preceding Claims 5 through 12,
**characterized in that**,
downstream from the rectifier (5), there is a comparator (6) that has a predefinable, constant comparator threshold for setting the switching distance.

14. The sensor according to one of the preceding Claims 5 through 12,
**characterized in that**,
the switching distance of the sensor, with a constant comparator threshold, can preferably be set either via the predefinable level of the direct voltage supply U_{B} or via the level of the output voltage of the control generator (4).

## Revendications

1. Procédé de détection et d'évaluation électrique de petites variations de capacité pour conversion en un signal de commutation, faisant appel à un amplificateur électrique (1) dont le raccordement d'alimentation positif ou négatif (plus+, moins-) est mis à une source d'alimentation en tension continue positive ou négative (UB) et dont l'autre raccordement d'alimentation (plus+, moins-) est mis à un potentiel de référence, une électrode (2) disposée de façon à se déplacer dans un mouvement relatif par rapport à un objet à détecter (3) étant connectée à l'entrée de l'amplificateur (1), **caractérisé en ce que**
un signal de tension alternative de demi-ondes positives et négatives, tel qu'un signal à mode commun ou un signal rectangulaire est mis aux raccordements d'alimentation (plus+, moins-) de l'amplificateur (1), de sorte que la tension d'alimentation de l'amplificateur reste constante, l'amplificateur (1) et l'électrode (2) parcourant cependant une levée de tension à mode commun des demi-ondes positives et négatives du signal de tension alternative, et lors de la détection d'un objet (3), un signal (signal d'électrode) provenant de l'électrode (2) est amplifié dans l'amplificateur (1) et ce signal de tension alternative amplifié apparaissant à la sortie de l'amplificateur (1) est redressé ensuite dans un montage en redresseur et découplé de la tension alternative par rapport au potentiel de terre, utilisé en tant que tension ou courant continu pour l'évaluation, le signal de tension alternative amplifié redressé par rapport au potentiel de terre dépendant directement de la grandeur de la réactance entre l'électrode (2) et l'objet (3).

2. Procédé selon la revendication 1, **caractérisé en ce que**
l'amplificateur oscille en va-et-vient entre une valeur de tension minimale et une valeur maximale de sa tension d'alimentation (UB) en fonction des demi-ondes positives et négatives du signal de tension alternative par rapport au potentiel de terre.

3. Procédé selon la revendication 1, **caractérisé en ce que**
le signal de tension alternative de l'amplificateur possède une forme rectangulaire dont la fréquence de travail s'élève à environ 20 kHz ± 5 kHz.

4. Procédé selon l'une ou l'autre des revendications 1 ou 2,
**caractérisé en ce que** l'amplificateur possède, en matière de résistance élevée aux perturbations, un facteur d'amplification de tension petit, de préférence de 1: 0,5 jusqu'à 1 : 100, en particulier de 1 : 1.

5. Capteur capacitif de détection et d'évaluation électrique de petites variations de capacité pour la conversion en un signal de commutation, avec un amplificateur électrique (1) dont le raccordement d'alimentation positif ou négatif (plus+, moins-) est mis à une source d'alimentation en tension continue positive ou négative (UB) et dont l'autre raccordement d'alimentation (plus+, moins-) est mis à un potentiel de référence, une électrode (2) disposée de façon à se déplacer dans un mouvement relatif par rapport à un objet à détecter (3) étant connectée à l'entrée de l'amplificateur (1), **caractérisé en ce que**
un signal de tension alternative de demi-ondes positives et négatives, tel qu'un signal à mode commun ou un signal rectangulaire est appliqué aux raccordements d'alimentation (plus+, moins-) de l'amplificateur (1), de sorte que la tension d'alimentation de l'amplificateur reste constante, l'amplificateur (1) et l'électrode (2) parcourant cependant une levée de tension à mode commun des demi-ondes positives et négatives du signal de tension alternative, et lors de la détection d'un objet (3) un signal (signal d'électrode) provenant de l'électrode (2) est amplifié dans l'amplificateur (1) et ce signal de tension alternative amplifié apparaissant à la sortie de l'amplificateur (1) est redressé ensuite dans un montage en redresseur et découplé de la tension alternative par rapport au potentiel de terre, utilisé en tant que tension ou courant continu pour l'évaluation, le signal de tension alternative amplifié redressé par rapport au potentiel de terre dépendant directement de la grandeur de la réactance entre l'électrode (2) et l'objet (3).

6. Capteur selon la revendication 5, **caractérisé en ce que**
la levée de la tension dépend de la différence de niveau de l'alimentation en tension continue et de l'amplitude du signal de tension alternative.

7. Capteur selon l'une des revendications 5 ou 6, **caractérisé en ce que**
l'amplitude du signal de tension alternative dans la demi-onde positive est égale au niveau de l'alimentation en tension continue UB et présente dans la demi-onde négative un potentiel de masse ou zéro volt, de sorte que la levée de tension qui résulte des élévations de tension aux raccordements d'alimentation (plus+, moins-) présente le niveau de la tension continue UB et reste constant.

8. Capteur selon la revendication 7, **caractérisé en ce que**
un générateur pilote (4) est connecté à l'amplificateur (1) lequel générateur génère le signal de tension alternative des demi-ondes positives et négatives, tel qu'un signal à mode commun ou un signal rectangulaire, le générateur pilote (4) étant relié d'une part directement au raccordement d'alimentation négatif (moins-) de l'amplificateur (1), l'entrée - ou l'entrée de la masse, et d'autre part, via un condensateur (Ch) au raccordement d'alimentation positif (plus+) de l'amplificateur (1), l'entrée plus, à laquelle est reliée via une diode (D) la source d'alimentation en tension continue UB, ou **en ce que** le générateur pilote (4) est relié d'une part directement au raccordement d'alimentation positif (+) de l'amplificateur (1), l'entrée (+), et d'autre part, via un condensateur (Ch) au raccordement d'alimentation négatif (-) de l'amplificateur (1), l'entrée moins ou l'entrée de la masse (-), la diode étant intercalée avec une polarité inversée entre le raccordement moins (-) de l'amplificateur (1) et la masse, de sorte que l'amplificateur (1), en son raccordement d'alimentation positif ou négatif (plus+, moins-) de la demi-onde positive ou négative ou vice-versa, parcourt une levée de tension allant du niveau simple au niveau double de l'alimentation en tension continue (UB), et en son raccordement d'alimentation négatif ou positif (plus+, moins-) ou vice versa, parcourt une levée de tension depuis le potentiel de référence, de préférence le potentiel de terre, jusqu'au niveau de l'alimentation en tension continue (UB) et la différence des levées de tension reste constante, à savoir au niveau de la tension d'alimentation (UB).

9. Capteur selon l'une ou l'autre des revendications 5 ou 6 ou 7,
**caractérisé en ce que** le signal de sortie du générateur pilote (4) est transmis en même temps en technique NPN et en technique PNP sur deux émetteurs-suiveurs montés symétriquement, les sorties des émetteurs-suiveurs étant reliées respectivement aux raccordements positif et négatif (plus+, moins-) de l'amplificateur (1).

10. Capteur selon la revendication 9, **caractérisé en ce que**
le générateur pilote (4) est relié par une combinaison résistance-capacité (R5, C_) au point de bifurcation commun de l'émetteur-suiveur, la résistance (R5) de la combinaison résistance-capacité déterminant l'amplitude de l'amplificateur (1) par rapport à la résistance totale.

11. Capteur selon l'une ou l'autre des revendications 5 ou 6 ou 7,
**caractérisé en ce que** l'amplificateur (1) possède une allure d'amplitude constante à l'intérieur d'une bande passante déterminée, de sorte que des champs brouilleurs à basse fréquence, tels que des champs ondulés ou des fréquences de l'ordre de 50 Hz, ou des hautes fréquences de préférence au-delà de 150 kHz sont coupées et que la fréquence de travail du générateur pilote (4) se situe à l'intérieur de cette bande passante déterminée sans incidence sur l'écart de commutation.

12. Capteur selon l'une ou l'autre des revendications 5 ou 6 ou 7,
**caractérisé en ce que** l'amplificateur présente un filtre passe-bande avec une amplification maximale pour une fréquence déterminée et la fréquence de travail du générateur pilote (4) est réglable et variable, de sorte que s'effectue de cette manière le réglage de sensibilité du capteur.

13. Capteur selon l'une des revendications ci-avant 5 à 12,
**caractérisé en ce que** un comparateur (6) est connecté en aval du redresseur de courant (5), lequel comparateur présente un seuil comparateur constant programmable destiné au réglage de l'écart de commutation.

14. Capteur selon l'une des revendications ci-avant 5 à 12,
**caractérisé en ce que** l'écart de commutation du capteur, étant donné un seuil comparateur constant, est réglable ou bien par le niveau de l'alimentation en tension continue UB programmable, ou bien par le niveau de la tension de sortie du générateur pilote (4).
